# EUROPEAN PATENT APPLICATION

(11) **EP 0 789 405 A2**
(43) Date of publication of application: **13.08.1997**
(21) Application number: 97100553.3
(22) Date of filing: 15.01.1997
(51) Int. Cl.: H01L 31/052, H01L 31/0236

(54) **Method of cooling solar cells**

(30) Priority: 07.02.1996 JP 21369/96
(71) Applicant: TOYOTA JIDOSHA KABUSHIKI KAISHA, Aichi-ken 471 (JP)
(72) Inventor: Tange, Kyoichi, Toyota-shi, Aichi-ken 471-71 (JP); Okawa, Susumu, Toyota-shi, Aichi-ken 471-71 (JP)
(74) Representative: KUHNEN, WACKER & PARTNER

(57) **Abstract**

A solar cell is disposed on the lower wall of a pipe and a plate-shaped optically transparent piece formed of a material which transmits light covers a window provided at a position in the upper wall of the pipe opposite to the solar cell so as to provide a method of efficiently and effectively cooling the cell. Sunlight is made to converge by a converging lens on a light receiving surface of the solar cell via the optically transparent piece. Coolant flows through the pipe, the light receiving surface of the solar cell is directly cooled by this coolant, and the heat of the sunlight converged by the converging lens is thereby removed by the coolant.

## Description

### BACKGROUND OF THE INVENTION

### FIELD OF THE INVENTION

This invention relates to solar cells, and in particular to a method of cooling solar cells to prevent deterioration of their power generating capacity.

### DESCRIPTION OF THE RELATED ART

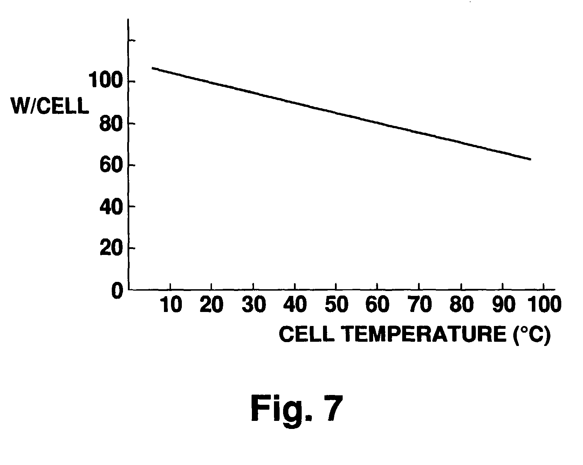

In general, the power generating capacity of solar cells decreases when their temperature rises. Fig. 7 shows the relation between the temperature of solar cells and the power output by the cells (W/cell) in the case of monocrystalline silicon (Si) solar cells. In Fig. 7, the horizontal axis shows solar cell temperature, and the vertical axis shows power output of the cells (W/cell).

As shown in Fig. 7, the power generating capacity of the cells decreases as the cell temperature rises. For example, the power generated when the cell temperature is 100°C is approx. 60% of the power generated at 25°C. The reason for this decrease is thought to be that as the temperature of the cells rises, molecular motion in the cell substrate material becomes more intense so that movement of holes and electrons, which are carriers of charge produced by an photoelectric effect, is impeded.

When the temperature of the solar cells becomes excessive, the insulating material or the materials of which the solar cells are made may break down or expand, shortening cell lifetime.

Conventionally, solar cells have been cooled to prevent decrease of their power generating capacity and increase their lifetime. An example of cooling solar cells is given in Japanese Patent Laid-Open Publication No. Hei 5-83881. According to this example, a solar module formed by arranging a plurality of solar cells on a cell stage is cooled by immersion in water using a jacket technique. A technique is also disclosed wherein a water cooling tube is installed on the underside of the module so that an electrode-inducing end does not become wet.

Another cooling method is to install an air cooling fin on the underside of the module. Alternatively, to cool modules used in a moving body such as a solar car, the upper surface of the solar cells may be covered with a thin resin and the body cooled by air as it moves. Conversely, no cooling device may be installed so as to avoid cost increases.

In recent years, a light converging type of solar cell has become popular wherein a converging lens is used to increase the amount of incident light falling on the cells and thereby permit reduction of their area. This shortens the number of energy recovery years or energy payback period (i.e., the number of years in which the energy used in manufacturing the module can be recovered as power output), and reduces the cost of a power generating system. In such a converging type solar cell, however, temperature increases also become larger as converging power increases.

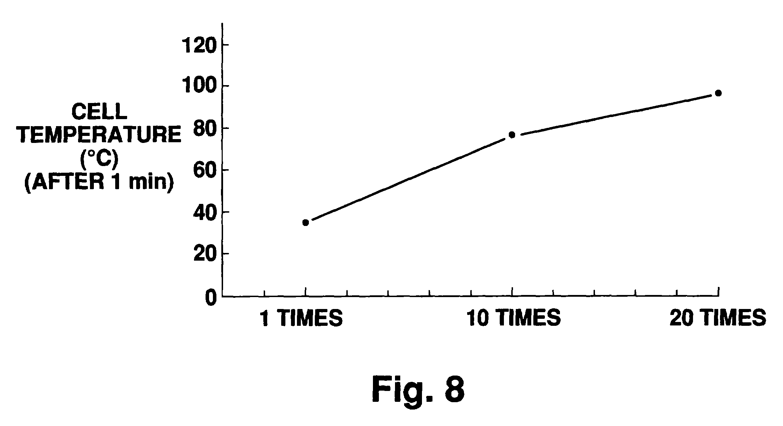

Fig. 8 shows the relationship between power increase of the module converging lens and temperature rise of the solar cell. In Fig. 8, the horizontal axis shows converging power and the vertical axis shows cell temperature. The value of the cell temperature on the vertical axis of Fig. 8 is the temperature of the cell one minute after beginning exposure of the cell to solar irradiation without cooling.

It is apparent from Fig. 8 that as the converging power is increased, the cell temperature also increases. A converging power of 1 means that no converging effect is applied, the solar energy falling on the cell in this case being 0.1W/cm². For a converging power of 10, the solar energy supplied to the cell is 1W/cm², and for a converging power of 20, the solar energy is 2W/cm².

If the cell is not cooled, its temperature rises when it is operated and the power generated by the cell falls as shown in Fig. 7. Consequently the solar energy input to the cell cannot be fully recovered despite the fact that the light was converged to increase this energy, and it is therefore necessary to cool a light converging type of solar cell. However instead of directly cooling each cell by water or another coolant, when the cells were incorporated in a solar cell module and the module was cooled by immersion in water as described hereinabove, cooling took place indirectly through the outer casing of the module. This meant that the cooling effect was insufficient. Also, when a water cooling pipe or air cooling fin was installed underneath the module, or installed on a moving body which was air-cooled, the cells were not cooled directly, and consequently sufficient cooling could not be achieved.

### SUMMARY OF THE INVENTION

This invention, which was conceived in view of the above problems, therefore aims to provide a more effective method of cooling solar cells.

In order to achieve this objective, according to a first aspect of this invention, there is provided a method of cooling solar cells wherein a light receiving surface of a cell is directly cooled by a coolant.

According to a second aspect of this invention, an electrode is formed on a surface opposite to the light receiving surface of the solar cell according to the first aspect.

According to a third aspect of this invention, a coolant is supplied as a pulsative flow to the light receiving surface of the solar cell according to the first aspect.

According to a fourth aspect of this invention, the light receiving surface of the solar cell according to the third aspect has an inverted pyramid texture.

According to a fifth aspect of this invention, the coolant is supplied as a jet spray to the light receiving surface of the solar cell according to the first aspect.

According to a sixth aspect of this invention, the coolant absorbs light of longer wavelength than the wavelength of light corresponding to the band gap of the semiconductor material used to manufacture the solar cell according to the first aspect.

According to a seventh aspect of this invention, the coolant according to the sixth aspect is either an aqueous solution of barium sulfate or an aqueous solution of NaCl.

According to an eighth aspect of this invention, a method of direct cooling is provided wherein a solar cell is disposed on one wall of a pipe of rectangular cross-section, a window of an optically transparent material for collecting sunlight is disposed on the opposite wall of the pipe facing the solar cell, and coolant is supplied via the pipe to the light receiving surface of the cell so that the surface is directly cooled, the distance between the surface and the optically transparent material being 0.5-2mm.

According to a ninth aspect of this invention, the diameter of the pipe according to the eighth aspect is greater than the distance between the light receiving surface of the solar cell and the optically transparent material in parts other than the parts where the solar cell and window are formed.

According to a tenth aspect of this invention, a thin film of Ag is formed on the surface of the optically transparent material in contact with the coolant according to the eighth aspect.

According to an eleventh aspect of this invention, a concave lens is used as the optically transparent material according to the eighth aspect.

### BRIEF DESCRIPTION OF THE DRAWINGS

Fig. 1 is a diagram in cross-section of a first embodiment of the method of cooling a solar cell according to this invention.

Fig. 2(a) and 2(b) are views in perspective of a solar cell used in the first embodiment shown in Fig. 1.

Fig. 3 is a diagram showing one modification of a pipe according to the first embodiment shown in Fig. 1.

Fig. 4 is a diagram showing another modification of the pipe according to the first embodiment shown in Fig. 1.

Fig. 5 is a diagram in cross-section of a fourth embodiment of the method of cooling a solar cell according to this invention.

Fig. 6 is a diagram in cross-section of a fifth embodiment of the method of cooling a solar cell according to this invention.

Fig. 7 is a diagram showing a relation between the temperature of a solar cell and the power generating capacity of the cell.

Fig. 8 is a diagram showing a relation between the converging power of a lens and the temperature of a solar cell.

### DESCRIPTION OF THE PREFERRED EMBODIMENTS

Some preferred embodiments of this invention will now be described with reference to the drawings.

### Embodiment 1

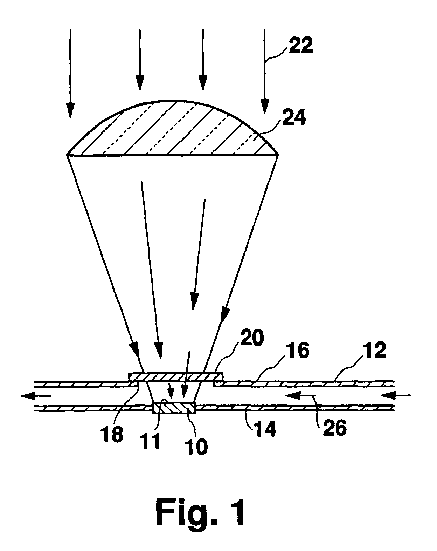

Fig. 1 shows a diagram in cross-section of a first embodiment of the method of cooling solar cells according to this invention. In Fig. 1, a solar cell 10 is disposed on a lower wall 14 of a pipe 12 with rectangular cross-section, and a window 18 for collecting sunlight is disposed on a upper wall 16 of a pipe 12 in a position facing the cell 10. A flat, optically transparent piece 20 such as a glass or transparent resin plate covers this window 18. A converging lens 24 is also fixed to a solar module, not shown, in order to converge sunlight 22 on a light receiving surface 11 of the cell 10 via the optically transparent piece 20. It will be understood that although only one of the cells 10 and one of the lenses 24 are shown for the sake of clarity, a solar module will in practice comprise a plurality of the cells 10 and lenses 24.

A coolant 26 flows through the aforesaid pipe 12 so that the surfaces of each of the solar cells 10 are directly cooled by the coolant 26. The coolant 26 is usually water, but alcohol, acetone or flon, etc., may also be used according to the application.

The dimensions of the converging lens 24 shown in Fig. 1 depend on the application, however where it is advantageous to make the solar module thin for application to vehicles or residences, the focal length of this lens 24 should be small. A lens of small diameter and high curvature is therefore used. From the viewpoint of reducing light absorption by the lens 24, it is not however advantageous to increase the curvature of the lens 24 such that its thickness increases, hence it is desirable to reduce its diameter while retaining a similar contour and without changing the material and curvature. For a large lens and small lens of similar contour, light is refracted by the same amount at corresponding positions on the lenses, so the focus approaches the lens by an amount depending on its reduction in size and consequently the focal length becomes shorter. A flat Fresnel lens or the like may also be used as the converging lens 24.

The converging lens 24 may for example be a spherical lens of diameter 20-80 mm, or a 20-80 mm rectangular lens having the shape of a square, and their focal lengths may be of the order of 30-100 mm.

In view of its application to residences or vehicles, the solar cell 10 shown in Fig. 1 should preferably be of a high efficiency crystalline silicon type, but chemical compound type solar cells such as GaAs, CdTe, CdS, CIS (CuInse) may also be used depending on the case.

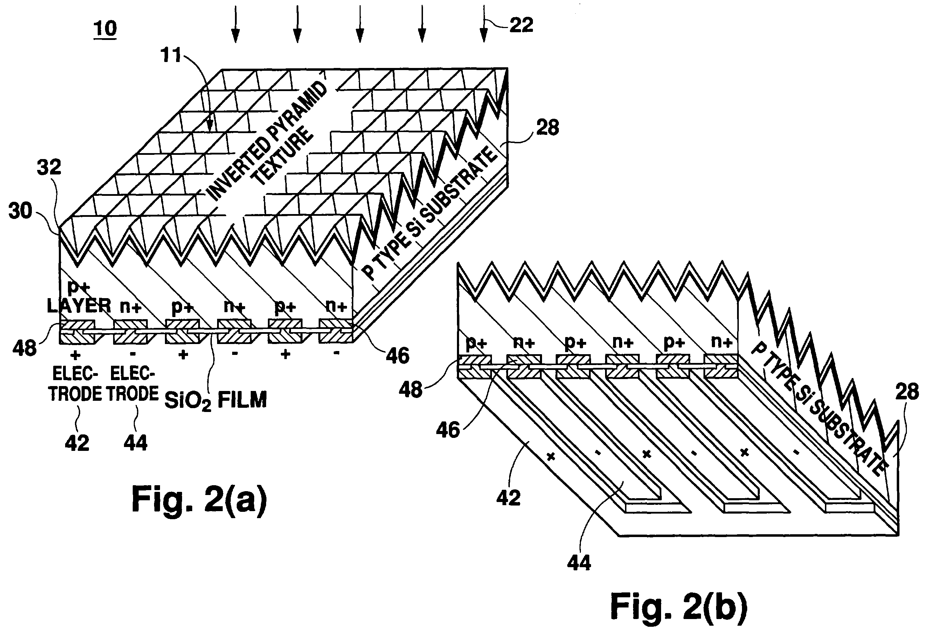

When a direct coolant 26 is introduced on the light receiving surface 11 of the solar cell 10 as in the case of this embodiment and metal electrodes are on the surface 11, corrosion may occur and the cell will consequently be unable to withstand long periods of use. In the solar cell 10 according to this embodiment, therefore, positive electrodes 42 and negative electrodes 44 are disposed on the underside of the cell 10 opposite to the light receiving surface 11 so that these electrodes do not come in direct contact with the coolant 26, as shown in Fig. 2(a) and (b). In the solar cell 10 shown in Fig. 2(a) and (b), the cells may comprise monocrystalline silicon (Si) or polycrystalline silicon.

As shown in Fig. 2(a), in the solar cell 10, a substrate 28 comprises p type Si, and the light receiving surface 11 of the substrate 28 has an inverted pyramid texture so as to fully absorb the sunlight 22. The rough texture formed on this substrate 28 is covered by a passivation film 30, this passivation film 30 being further covered by a reflection preventing film 32.

The p type Si substrate 28 has an impurity concentration of the order of 10¹⁵-10¹⁶ cm⁻³ to increase the lifetime of the carriers as much as possible, and its resistivity corresponds to 100-1000 Ω cm. As shown in Fig. 2(b), on the underside of the solar cell opposite to the light receiving surface 11 on which the rough texture is formed, n⁺ layers 46 and p⁺ layers 48 are formed alternately. Negative electrodes 44 are formed on the n⁺ layers 46 and positive electrodes 42 are formed on the p⁺ layers 48 respectively, the positive electrodes 42 being connected in parallel and the negative electrodes 44 being connected in parallel. In such a structure, carriers can be effectively withdrawn from the entire surface of the solar cell 10.

In the arrangement shown in Fig. 1, sunlight reaches the light receiving surface 11 of the solar cell 10 after passing through the coolant 26, and part of the sunlight is absorbed by the coolant 26. It is therefore desirable to keep the distance between the light receiving surface 11 of the solar cell 10 and the transparent piece 20 as small as possible, 0.5 mm - 2 mm being suitable. When the distance between the light receiving surface 11 and the transparent piece 20 is less than the lower limit of this range, the cross-sectional area of the pipe 12 becomes smaller, the pressure drop of the coolant 26 flowing through the pipe 12 increases, and the energy consumed by the pump which circulates the coolant 26 increases leading to higher energy losses. In this case, the flow of coolant 26 over the light receiving surface 11 of the solar cell 10 may also become uneven. Conversely, when the aforesaid distance is greater than the upper limit of the above range, losses of sunlight increase due to absorption as described hereinabove.

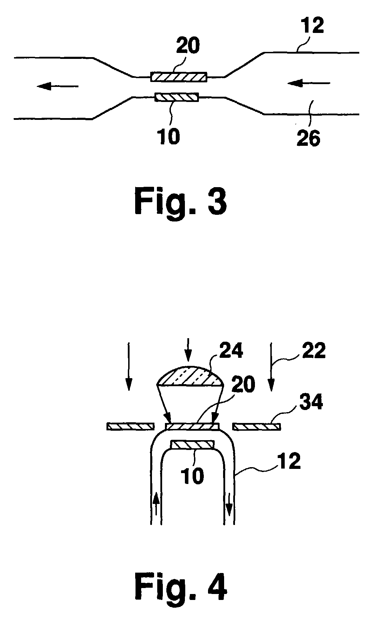

To decrease pressure drop when the coolant 26 flows through the pipe 12, decrease the energy consumed by the pump which circulates the coolant 26 and decrease sunlight losses, it is effective for example to reduce the diameter of the pipe 12 only in the part adjoining the solar cell 10, the diameter being relatively large in other parts, shown in Fig. 3.

When flon or the like is used as the coolant, the temperature of the pipe 12 rises when it is irradiated by sunlight, and the liquid flon flowing through the pipe 12 may vaporize. If the flon in the pipe 12 vaporizes, the cooling effect of the solar cell 10 declines. To avoid this, the pipe 12 may be disposed in a vertical direction, i.e., in the same direction as the propagation direction of the sunlight 22 as shown in Fig. 4, only that part of the pipe adjoining the solar cell 10 being horizontal so as to fully absorb the sunlight 22. In such a case, the part of the pipe which is vertically disposed is shielded by a piece 34 so that sunlight does not shine on it. This prevents parts of the pipe 12 other than those where the solar cell 10 is formed from being irradiated by the sunlight, and prevents vaporization of flon coolant in the pipe 12.

Table 1 shows a comparison of the cooling effect obtained by the solar cell cooling method according to this embodiment and that obtained by the prior art. The solar cell 10 used comprised monocrystalline Si having the rough texture shown in Fig. 2, and the coolant was water at 20°C. The convergence of the sunlight was 20 times in all cases.

Three cases are shown for the prior art, i.e., the case where the solar cell module is not cooled, the case where the module is air-cooled by attaching a fin to its underside, and the case where the module is indirectly cooled by disposing a water cooling pipe on its underside. For this embodiment, the case is shown where the solar cell 10 is directly cooled by the method illustrated in Fig. 1.

It is seen from Table 1 that at 1, 2 or 3 minutes after beginning irradiation with sunlight and when the solar cell is operating normally, the cooling effect obtained by the method according to this embodiment is superior to that obtained by any of the prior art examples, and there is less scatter of temperature in the cell. Hence, it may be anticipated that when a plurality of the cells 10 is integrated in a module, scatter of solar cell characteristics will also be suppressed.

**Table 1**

| | COOLING METHOD | ONE MINUTE AFTER STARTING IRRADIATION WITH SUNLIGHT | AFTER 2 MINUTES | AFTER 3 MINUTES | DURING NORMAL OPERATION |
|---|---|---|---|---|---|
| PRIOR ART EXAMPLE | NONE | 98°C | 138°C | 180°C | 170°C∼ 195°C |
| | AIR COOLING OF MODULE UNDERSIDE BY FIN | 63°C | 93°C | 124°C | 120°C∼ 140°C |
| | INDIRECT COOLING OF MODULE UNDERSIDE BY WATER COOLING PIPE | 48°C | 63°C | 82°C | 80°C∼ 85°C |
| THIS EMBODIMENT | DIRECT COOLING (Fig. 1) | 27°C | 29°C | 29°C | 28°C∼ 29°C |

### Embodiment 2

In general, sunlight contains light which contributes, and light which does not contribute, to the photoelectric effect of the cell 10. When the solar cell 10 is formed of Si, the band gap is 1.1 eV, so only light of shorter wavelength than approx. 1120 nm can contribute to the photoelectric effect. If, therefore, light of longer wavelength which cannot contribute to the photoelectric effect of the cell 10 is absorbed by the coolant without irradiating the surface 11, and thereby removed outside the device, temperature rise of the solar cell 10 may be still further suppressed and cooling potential enhanced.

Due to the above, according to this embodiment, a material is employed as coolant which absorbs light of longer wavelength than the wavelength corresponding to the band gap of the semiconductor material used.

The coolant must not however absorb shorter wavelengths which contribute to the photoelectric effect of the solar cell 10, and must therefore have a selective absorption function. For this purpose, an aqueous solution of barium sulfate or an aqueous solution of NaCl are for example suitable. Alternatively, a thin Ag film of for example several 100 Angstroms thickness may be vapor deposited on the underside, i.e., the side in contact with the coolant, of the transparent piece 20 in Fig. 1.

According to this embodiment, the operating temperature of the solar cell 10 in Table 1 may be lowered by 2 - 3°C compared to the case where water alone is used as coolant.

### Embodiment 3

According to Embodiment 1 the coolant was made to flow continuously, but if it is given a pulsative flow, the overall flowrate can be reduced and the power consumed by the pump is correspondingly reduced. Conversely, when the power consumed by the pump is the same, the peak flowrate for pulsative flow may be made larger than the flowrate for continuous flow. In this context, the term pulsative flow means a flow in which the flowrate varies.

Table 2 gives a comparison of cooling effect for continuous flow and pulsative flow when the light receiving surface 11 of the solar cell 10 is a mirror surface and when it has a rough texture. It should be noted that the temperature shown in Table 2 is the temperature when the solar cell reached a steady state at a converging power of 50, and that the temperature of the cooling water used was 20°C. Various types of pulsative flowrate pattern may be envisaged, however in the experiment shown in Table 2, the peak flowrate of the pulsative flow is the same as that of continuous flow and the power consumed by the pump is approx. 1/2 - 4/5.

It may be seen from Table 2 that whether the light receiving surface 11 is a mirror surface or has a rough

**Table 2**

| | CONTINUOUS FLOW | | PULSATIVE FLOW | | |
|---|---|---|---|---|---|
| | 10cm/s | 20cm/s | PEAK 10cm/s | PEAK 20cm/s | PEAK 30cm/s |
| MIRROR SURFACE | 43°C | 35°C | 42°C | 35°C | 33°C |
| TEXTURED SURFACE | 52°C | 43°C | 52°C | 44°C | 38°C |
| POWER CONSUMPTION | 30 w | 65 w | 24 w | 48 w | 65 w |

texture, when the peak flowrate for pulsative flow is arranged to be the same as that for continuous flow, the solar cell is cooled by about the same amount as for continuous flow. The power consumption of the pump can however be reduced to about 70% - 80% for pulsative flow as compared to continuous flow.

When the power consumption of the pump was 65W, the flowrate of continuous flow was 20 cm/s, but for pulsative flow, the peak flowrate was 30 cm/s. In pulsative flow there are times when the flowrate is higher than in continuous flow, and it is thought that a layer of water which remains on the light receiving surface 11 and which presents a resistance to thermal conduction is removed due to the high flowrate so that the cooling effect is increased.

When the light receiving surface 11 of the solar cell has a rough texture, the cooling effect is less than for a mirror surface, however when a pulsative flow is used the peak flowrate can be set high without increasing the power consumption of the pump so that the cell can be cooled to a sufficiently low temperature (38°C for a pump power consumption of 65W and a maximum flowrate of 30 cm/s).

### Embodiment 4

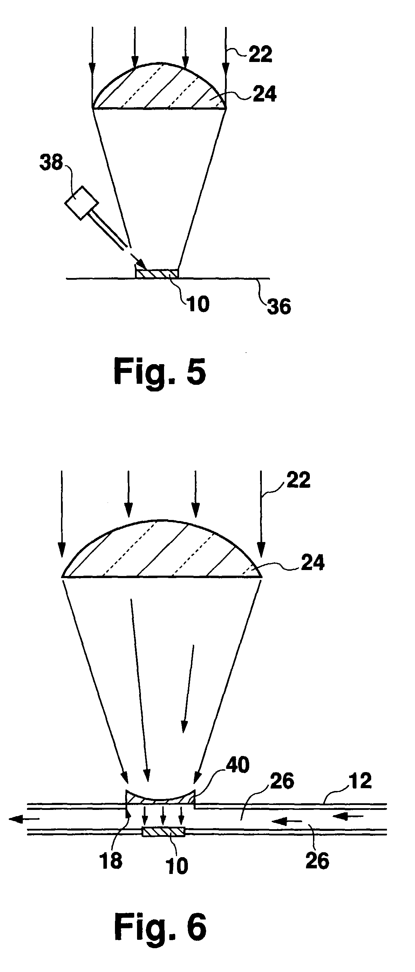

Fig. 5 shows a section of a fourth embodiment of the method of cooling a solar cell according to this invention. In Fig. 5, the solar cell 10 is mounted on a cell stage 36, and a coolant nozzle 38 is installed above the solar cell 10 at an oblique angle. A jet of coolant is sprayed continuously or intermittently by the cooling nozzle 38 so as to impinge on the solar cell 10. In this case, the spray amount of coolant used is for example of the order of 10 - 20 cc/cm² per minute.

By means of the aforesaid construction, using cooling water at 20°C as coolant, the solar cell may be cooled to 30°C or below when the sunlight 22 is converged by a power of 50, i.e., under the same conditions as those shown in Table 2.

Table 3 shows a comparison of cooling effects and solar cell outputs according to the prior art and according to Embodiment 1 and Embodiment 4 of this invention.

Table 3 shows the case when a water cooling pipe is disposed adjacent to the underside of the solar module so as to cool the cell indirectly as an example of the prior art, the case where the solar cell 10 is cooled by the method shown in Fig. 5 as an example of Embodiment 4, and the case where the solar cell 10 is cooled by the method of Fig. 1 as an example of Embodiment 1. In the solar cell 10, a rough texture is formed on the light receiving surface 11, and the values given for cell temperature and cell output both correspond to the case when the sunlight is converged by a power of 50.

As can be seen from Table 3, when the method of Embodiment 4 is used, the running temperature of the cell may be reduced to a minimum of 27°C even when the solar cell 10 having the

**Table 3**

| | | | CONVERGING POWER OF 50 | | |
|---|---|---|---|---|---|
| | COOLING METHOD | POWER CONSUMPTION OF WATER COOLING PUMP (w/cell) | CELL TEMPERATURE | CELL OUTPUT | TOTAL OUTPUT |
| PRIOR ART EXAMPLE | INDIRECT COOLING OF MODULE UNDERSIDE BY WATER COOLING PIPE | 0.1 w/cell | 140°C∼ 170°C | 0.3∼0.4 w/cell | 0.2∼0.3 w/cell |
| EMBODIMENT 4 | Fig. 5 | 0.02 w/cell | 27°C | 0.78 w/cell | 0.76 w/cell |
| EMBODIMENT 1 | Fig. 1 | 0.1 w/cell | 36°C | 0.76 w/cell | 0.66 w/cell |

light receiving surface 11 with a rough texture is used. Moreover, as the cell temperature may be reduced far lower in Embodiment 1 and Embodiment 4 than in the conventional case, the cell output may be greatly increased in both cases compared to the prior art. As a result, the total output of the solar cell which is obtained by subtracting the power consumption of the pump from the cell output may be largely increased in both Embodiment 1 and Embodiment 4 as compared to the prior art, and the power generating efficiency per cell may be remarkably improved. In particular, in Embodiment 4, the flowrate of coolant used is greatly reduced, therefore the power consumption of the pump can be greatly reduced by a corresponding amount and the power generating efficiency per cell may be increased.

Also in Embodiment 4, the transparent piece of glass 20 or similar material is unnecessary, so there is also no attenuation of sunlight due to this piece 20.

### Embodiment 5

Fig. 6 is a view in section of a fifth embodiment of the method of cooling a solar cell according to this invention.

In Fig. 6, the difference from Embodiment 1 is that a concave lens 40 is installed instead of the plate-shaped optically transparent piece in the window 18 formed in the pipe 12.

The sunlight 22 converged by the converging lens 24 is converted by the concave lens 40 to a parallel beam which is perpendicular to the light receiving surface 11 of the solar cell 10, and irradiates the light receiving surface 11 of the cell 10 with a uniform light intensity. This renders the generated carrier distribution inside the solar cell 10 more uniform and renders the potential distribution set up in the cell 10 more uniform, so the power output obtained is increased.

Table 4 shows a comparison of the total output per solar cell, i.e. the value obtained by subtracting the power consumption of the pump from the power generated by the solar cell 10, in the case of Embodiment 1 and Embodiment 5.

As shown in Table 4, in any of the above cases, the temperature of the solar cell is effectively the same, however the total output is increased in Embodiment 5.

As described hereinabove, according to this invention, the light receiving surface of the solar cell can be directly cooled by the coolant, hence the temperature of the cell can be efficiently and effectively decreased. As a result, the power generating efficiency of the cell is improved, and the lifetime of the cell is lengthened.

Further, as the electrodes of the solar cell are formed on the underside of the cell opposite to the light receiving surface, corrosion of the electrodes may be avoided even when

**Table 4**

| | CELL TEMPERATURE | TOTAL OUTPUT |
|---|---|---|
| EMBODIMENT 1 | 36°C | 0.66 w/cell |
| EMBODIMENT 5 | 37°C | 0.69∼0.71 w/cell |

the light receiving surface is directly cooled.

By making the flow of coolant which cools the solar cell a pulsative flow, the cooling effect may be enhanced.

By jet spraying the coolant which cools the solar cell, the cell may be effectively cooled even when only a small amount of coolant is used.

As a further example, when silicon is used as a semiconductor material, the band gap is 1.1 eV, only light which is of shorter wavelength than approx. 1120 nm contributes to the photoelectric effect, and light of longer wavelength is absorbed by the coolant so temperature rise of the solar cell may be further suppressed.

## Claims

1. A method of cooling a solar cell wherein a light receiving surface of said solar cell is directly cooled by a coolant.

2. A method of cooling a solar cell as defined in claim 1, wherein an electrode is formed on a surface opposite to said light receiving surface.

3. A method of cooling a solar cell as defined in claim 1, wherein said coolant is supplied to said light receiving surface by a pulsative flow.

4. A method of cooling a solar cell as defined in claim 3, wherein said light receiving surface has an inverted pyramid texture.

5. A method of cooling a solar cell as defined in claim 1, wherein said coolant is supplied to said light receiving surface as a jet spray.

6. A method of cooling a solar cell as defined in claim 1, wherein said coolant comprises a material which absorbs light of longer wavelengths than light corresponding to a band gap of a semiconductor material used to manufacture said solar cell.

7. A method of cooling a solar cell as defined in claim 6, wherein either an aqueous solution of barium sulfate or an aqueous solution of NaCl is used as said coolant.

8. A method of cooling a solar cell wherein a solar cell is disposed on one wall of a pipe of rectangular cross-section, a window for collecting sunlight in which an optically transparent piece is installed is disposed in another wall of said pipe in a position opposite said solar cell, and a coolant is supplied via said pipe to a light receiving surface of said solar cell so as to directly cool said light receiving surface by said coolant,
the distance between said light receiving surface of said solar cell and said optically transparent piece lying in the range 0.5 - 2 mm.

9. A method of cooling a solar cell as defined in claim 8, wherein the diameter of said pipe in parts other than those in which said solar cell and said window are formed, is larger than the distance between the light receiving surface of said solar cell and said optically transparent piece.

10. A method of cooling a solar cell as defined in claim 8, wherein a thin film of Ag is formed on the surface of said optically transparent piece in contact with said coolant.

11. A method of cooling a solar cell as defined in claim 8, wherein a concave lens is used as said optically transparent piece.
